# EUROPEAN PATENT APPLICATION

(11) **EP 4 808 315 A1**
(43) Date of publication of application: **16.09.2026**
(21) Application number: 25209948.6
(22) Date of filing: 21.10.2025
(51) Int. Cl.: H10F 71/00, H10F 77/70, H10F 77/20

(54) **SOLAR CELL AND MANUFACTURING METHOD THEREOF**

(30) Priority: 10.03.2025 CN 202510281687
(71) Applicant: Jinko Solar (Haining) Co., Ltd., Haining City, Zhejiang (CN)
(72) Inventor: ZONG, Xiaohui, Haining City, Zhejiang Province (CN); ZHANG, Yuanfang, Haining City, Zhejiang Province (CN); WANG, Zhao, Haining City, Zhejiang Province (CN); YANG, Jie, Haining City, Zhejiang Province (CN); ZHENG, Peiting, Haining City, Zhejiang Province (CN); ZHANG, Xinyu, Haining City, Zhejiang Province (CN); YU, Linglin, Haining City, Zhejiang Province (CN); JIANG, Linxiang, Haining City, Zhejiang Province (CN)
(74) Representative: Balder IP Law, S.L.

(57) **Abstract**

The present disclosure relates to the field of photovoltaic technology, and provides a solar cell and manufacturing method thereof. The method includes: providing a substrate including a first surface and an opposing second surface; forming a doped layer by performing doping treatment on at least the first surface using a first doping element; forming activated portions by performing first laser treatment on first portions of the doped layer, where second portions of the doped layer excluding the first portions form doped portions; removing the activated portions and forming first textured surfaces by performing first etching treatment on the first surface, where the doped portions function as dead layers; forming a first doped polycrystalline silicon layer including a second doping element and a first silicon glass layer on a side of the substrate away from the doped portions; forming porous portions by performing second laser treatment on at least first portions of the first silicon glass layer; and removing the porous portions and first portions of the first doped polycrystalline silicon layer beneath the porous portions and forming second textured surfaces by performing second etching treatment on at least the second surface, where second portions of the first silicon glass layer excluding the porous portions function as protection layers. The first doping element is different from the second doping element in type, the first laser treatment uses a laser of a first type, and the second laser treatment uses a laser of a second type different from the first type. The method is at least conducive to simplifying manufacturing processes of solar cells.

## Description

### TECHNICAL FIELD

The present disclosure relates to the technical field of photovoltaic technology, and in particular to a solar cell and a method for manufacturing a solar cell.

### BACKGROUND

With the gradual depletion of fossil energy, solar cells are used more and more widely as a new energy alternative. The solar cell is a device for converting solar light energy into electric energy. The solar cell generates carriers by utilizing the photovoltaic principle, and carriers are led out by grid lines, thereby effectively utilizing the electric energy.

At present, solar cells mainly include interdigitated back contact (IBC) solar cells, tunnel oxide passivated contact (TOPCON) solar cells, passivated emitter and rear cells (PERC), heterojunction solar cells, and the like.

The solar cells manufactured using various manufacturing methods have photoelectric conversion efficiency different from each other, and there is a need of finding a manufacturing method that is more conducive to improving the photoelectric conversion efficiency of solar cells or simplifying manufacturing processes.

### SUMMARY

Embodiments of the present disclosure provide a solar cell and a method for manufacturing a solar cell, which are at least conducive to simplifying manufacturing processes of solar cells and to improving the photoelectric conversion efficiency of solar cells.

In one aspect, some embodiments of the present disclosure provide a method for manufacturing a solar cell, including: providing a substrate including a first surface and an opposing second surface; forming a doped layer by performing doping treatment on at least the first surface using a first doping element; forming activated portions by performing first laser treatment on portions of the doped layer, where the doped layer further includes doped portions other than the activated portions, and doping concentration of the first doping element in the activated portions is lower than doping concentration in the doped portions; removing the activated portions and forming first textured surfaces by performing first etching treatment on the first surface, where the doped portions function as dead layers; forming a first doped polycrystalline silicon layer including a second doping element and a first silicon glass layer on a side of the substrate away from the doped portions, where the first silicon glass layer is formed on a surface of the first doped polycrystalline silicon layer away from the substrate; forming porous portions by performing second laser treatment on at least first portions of the first silicon glass layer; and removing the porous portions and first portions of the first doped polycrystalline silicon layer beneath the porous portions and forming second textured surfaces by performing second etching treatment on at least the side of the substrate away from the doped portions, where remaining second portions of the first silicon glass layer after removal of the porous portions function as protection layers. The first doping element has a conductivity type different from that of the second doping element, the first laser treatment uses a laser of a first type, and the second laser treatment uses a laser of a second type different from the first type.

In some embodiments, each of the first surface and the second surface is a third textured surface, and after forming the first textured surfaces and before forming the first doped polycrystalline silicon layer, the method further includes: forming a polished surface by performing polishing treatment on the second surface; and forming the first doped polycrystalline silicon layer and the first silicon glass layer, includes: forming the first doped polycrystalline silicon layer on the polished surface, and forming the first silicon glass layer on the surface of the first doped polycrystalline silicon layer away from the substrate.

In some embodiments, after forming the first textured surfaces and before forming the polished surface, the method further includes: forming a first diffusion-barrier layer on the doped portions and forming a second diffusion-barrier layer on the first textured surfaces by performing oxidation treatment on at least the first surface; and the method further includes: forming a second doped polycrystalline silicon layer on the first diffusion-barrier layer and the second diffusion-barrier layer, and forming a second silicon glass layer on a surface of the second doped polycrystalline silicon layer away from the substrate.

In some embodiments, after forming the first textured surfaces and before forming the polished surface, the method further includes: forming a first diffusion-barrier layer on the doped portions and forming a second diffusion-barrier layer on the first textured surfaces by performing oxidation treatment on at least the first surface, where the first diffusion-barrier layer and the second diffusion-barrier layer together form a surface having a periphery region and a center region surrounded by the periphery region; and the method further includes: forming a second doped polycrystalline silicon layer on the periphery region, and forming a second silicon glass layer on a surface of the second doped polycrystalline silicon layer away from the substrate.

In some embodiments, the first surface includes first laser regions and first laser-free regions alternately arranged along a first direction, and the second surface includes second laser regions and second laser-free regions alternately arranged along the first direction. Performing the first laser treatment on the portions of the doped layer, includes: performing the first laser treatment on the portions of the doped layer that are in the first laser regions to form the activated portions at the first laser regions; and performing the second laser treatment on at least the first portions of the first silicon glass layer, includes: performing the second laser treatment on the first portions of the first silicon glass layer that are in the second laser regions to form the porous portions at the second laser regions.

In some embodiments, a respective orthographic projection of each first laser region of at least some of the first laser regions on the substrate has an area different from an area of a respective orthographic projection of each second laser region of at least some of the second laser regions on the substrate; and/or a respective orthographic projection of each first laser region of at least some of the first laser regions on the substrate at least partially overlaps with a respective orthographic projection of each second laser region of at least some of the second laser regions on the substrate.

In some embodiments, a respective orthographic projection of each first laser region of at least some of the first laser regions on the substrate has an area different from an area of a respective orthographic projection of each second laser region of at least some of the second laser regions on the substrate; and/or in a second direction, a respective orthographic projection of each first laser region of at least some of the first laser regions on the substrate misaligns with a respective orthographic projection of each second laser region of at least some of the second laser regions on the substrate, where the second direction refers to a thickness direction of the substrate.

In some embodiments, removing the activated portions and forming the first textured surfaces by performing the first etching treatment on the first surface, includes: removing the activated portions and forming the first textured surfaces by etching the first surface using a first texturing process.

In some embodiments, an oxide layer is formed on the doped layer during the first laser treatment, and before etching the first surface using the first texturing process, the method further includes: removing the oxide layer by etching the first surface using a first chain hydrofluoric acid process.

In some embodiments, performing the second etching treatment on at least the side of the substrate away from the doped portions, includes: removing the second silicon glass layer by etching the first surface using a second chain hydrofluoric acid process; and etching the first surface and the second surface using a second texturing process to remove the second doped polycrystalline silicon layer, the first diffusion-barrier layer, and the second diffusion-barrier layer and expose the first textured surfaces and the doped portions, and to remove the porous portions and the first portions of the first doped polycrystalline silicon layer beneath the porous portions and form the second textured surfaces.

In some embodiments, after etching the first surface and the second surface using the second texturing process, the method further includes: removing the second portions of the first silicon glass layer at the second laser-free regions by washing the second surface using an acid-washing process to expose second portions of the first doped polycrystalline silicon layer at the second laser-free regions.

In some embodiments, forming the first textured surfaces, includes: forming the first textured surfaces and first grooves, where each first groove of the first grooves has a respective first textured surface of the first textured surfaces as a bottom surface.

In some embodiments, forming the second textured surfaces, includes: forming the second textured surfaces and second grooves, where each second groove of the second grooves has a respective second textured surface of the second textured surfaces as a bottom surface.

In some embodiments, the first laser treatment uses red nanosecond laser, green nanosecond laser, or purple nanosecond laser, and the second laser treatment uses green picosecond laser, purple picosecond laser, green femtosecond laser, or purple femtosecond laser.

In another aspect, some embodiments of the present disclosure provide a solar cell, the solar cell is manufactured by using the method according to any one of the above embodiments.

The technical solutions provided in the embodiments of the present disclosure have at least the advantages as follows.

On the one hand, the first laser treatment is used to activate portions of the doped layer, such that the doping concentration of the first doping element in the portions of the doped layer is reduced, and the orderliness of the lattice in the portions of the doped layer is improved, thereby converting these portions of the doped layer into activated portions, with the remaining portions of the doped layer forming the doped portions. In other words, compared to the doped portions, the doping concentration of the doping element in the activated portions is lower, which makes the overall orderliness of the lattice in the activated portions stronger. Therefore, under the same etching conditions, it is easier to etch the doped portions. On this basis, when the first surface is subsequently subjected to the first etching treatment, the etching rate for the activated portions having lower doping concentration of the first doping element is much higher than that for the doped portions. Thus, the activated portions can be removed and the first textured surfaces can be formed with the doped portions functioning as dead layers, without the need of providing additional masks, which is conducive to simplifying the manufacturing process of solar cells. In addition, compared to using laser ablation technology to remove portions of the doped layer and form selective emitter structures with the doped layer is remained in only some regions of the first surface, the combination of the first laser treatment and the first etching treatment is beneficial for reducing the laser damage to the first surface, thereby reducing the surface defect density at the first surface and improving the photoelectric conversion efficiency of the finally formed solar cells. Moreover, by forming the selective emitter structures with portions of the doped layer (i.e., the doped portions) are remained in some regions of the first surface, it is beneficial for reducing the contact resistance between the subsequently formed electrodes and the doped portions, and reducing the probability of recombination of carriers in other regions of the first surface.

On the other hand, the second laser treatment is used to modify portions of the first silicon glass layer into porous portions, resulting in a higher degree of porosity in the porous portions than in the remaining portions of the first silicon glass layer. On this basis, when performing the subsequent second etching treatment on at least the side of the substrate away from the doped portions, the etching rate for the porous portions having higher porosity is much higher than that for the remaining portions of the first silicon glass layer. Therefore, the porous portions and first portions of the first doped polycrystalline silicon layer beneath the porous portions can be removed and the second textured surfaces can be formed with the remaining portions of the first silicon glass layer functioning as protection layers, without the need of providing additional masks, which is conducive to simplifying the manufacturing process of solar cells. Moreover, removing the first portions of the first doped polycrystalline silicon layer beneath the porous portions is conducive to preventing parasitic absorption of light by the removed first portions of the first doped polycrystalline silicon layer.

### BRIEF DESCRIPTION OF THE DRAWINGS

Exemplary illustrations of one or more embodiments are provided by reference to pictures in the corresponding accompanying drawings. These exemplary illustrations do not constitute a limitation on the embodiments. The drawings do not constitute a scale limitation unless otherwise specified. In order to illustrate the technical solutions in related technologies or in the embodiments of the present disclosure more clearly, the drawings to be used in the embodiments will be briefly described below. It is obvious that the drawings mentioned in the following illustration are only some embodiments of the present disclosure. For those of ordinary skill in the art, other drawings may also be obtained in accordance with these drawings without any inventive effort.
FIG. 1 is a schematic diagram showing a structure of a partial cross-section of a substrate provided in a method for manufacturing a solar cell according to some embodiments of the present disclosure;
FIG. 2 is a schematic diagram showing a structure of a partial cross-section of a solar cell with the first surface being subjected to doping treatment in the method for manufacturing a solar cell according to some embodiments of the present disclosure;
FIG. 3 is a schematic diagram showing a structure of a partial cross-section of a solar cell being subjected to the first laser treatment in the method for manufacturing a solar cell according to some embodiments of the present disclosure;
FIG. 4 is a schematic diagram showing a structure of a partial cross-section of a solar cell being subjected to the first etching treatment in the method for manufacturing a solar cell according to some embodiments of the present disclosure;
FIG. 5 is a schematic diagram showing a structure of a partial cross-section of a solar cell with at least the first surface being subjected to oxidation treatment in the method for manufacturing a solar cell according to some embodiments of the present disclosure;
FIG. 6 is a schematic diagram showing a structure of the partial cross-section of the solar cell in FIG. 5, with the second surface being subjected to polishing treatment;
FIG. 7 is a schematic diagram showing a structure of the partial cross-section of the solar cell in FIG. 6, with the first doped polycrystalline silicon layer, the first silicon glass layer, the second doped polycrystalline silicon layer, and the second silicon glass layer being formed;
FIG. 8 is a schematic diagram showing a structure of a partial cross-section of a solar cell being subjected to the second laser treatment in the method for manufacturing a solar cell according to some embodiments of the present disclosure;
FIG. 9 is a schematic diagram showing a structure of the partial cross-section of the solar cell in FIG. 8, with the first surface being subjected to etching;
FIG. 10 is a schematic diagram showing a structure of the partial cross-section of the solar cell in FIG. 9, with the first surface and the second surface being subjected to texturing; and
FIG. 11 is a schematic diagram showing a structure of the partial cross-section of the solar cell in FIG. 10, with the second surface being subjected to washing.

### Description of reference numerals:

100, substrate; 110, first surface; 120, second surface; 130, third textured surface; 140, first laser region; 150, first laser-free region; 160, second laser region; 170, second laser-free region; 101, doped layer; 111, activated portion; 121, doped portion; 1021, first doped polycrystalline silicon layer; 1022, second doped polycrystalline silicon layer; 1031, first silicon glass layer; 1032, second silicon glass layer; 113, porous portions; 104, first groove; 114, first textured surface; 105, second groove; 115, second textured surface; 116, first diffusion-barrier layer; 126, second diffusion-barrier layer; 136, third diffusion-barrier layer; 108, second doped layer.

### DETAILED DESCRIPTION OF THE EMBODIMENTS

It is known from the background that manufacturing processes of solar cells need to be simplified, and the photoelectric conversion efficiency of solar cells needs to be improved.

Embodiments of the present disclosure provide a method for manufacturing a solar cell and a solar cell. In the method, on the one hand, the first laser treatment is used to activate portions of the doped layer, such that the doping concentration of the first doping element in the portions of the doped layer is reduced, such that the orderliness of the lattice in the portions of the doped layer is improved. In other words, compared to the doped portions, the doping concentration of the doping element in the activated portions is lower, which makes the overall orderliness of the lattice in the activated portions stronger. Therefore, under the same etching conditions, it is easier to etch the doped portions. On this basis, when the first surface is subsequently subjected to the first etching treatment, the etching rate for the activated portions having lower doping concentration of the first doping element is much higher than that for the doped portions. Thus, the activated portions can be removed and the first textured surfaces can be formed with the doped portions functioning as dead layers, without the need of providing additional masks, which is conducive to simplifying the manufacturing process of solar cells. In addition, compared to using laser ablation technology to remove portions of the doped layer, the combination of the first laser treatment and the first etching treatment is beneficial for reducing the laser damage to the first surface, thereby reducing the surface defect density at the first surface and improving the photoelectric conversion efficiency of the finally formed solar cells. Moreover, by forming the selective emitter structures with the doped portions are remained in some regions of the first surface, it is beneficial for reducing the contact resistance between the subsequently formed electrodes and the doped portions, and reducing the probability of recombination of carriers in other regions of the first surface. On the other hand, the second laser treatment is used to modify portions of the first silicon glass layer into porous portions. On this basis, when performing the subsequent second etching treatment on at least the side of the substrate away from the doped portions, the etching rate for the porous portions having higher porosity is much higher than that for the remaining portions of the first silicon glass layer. Therefore, the porous portions and first portions of the first doped polycrystalline silicon layer beneath the porous portions can be removed and the second textured surfaces can be formed with the remaining portions of the first silicon glass layer functioning as protection layers, without the need of providing additional masks, which is conducive to simplifying the manufacturing process of solar cells. Moreover, removing the first portions of the first doped polycrystalline silicon layer beneath the porous portions is conducive to preventing parasitic absorption of light by the removed first portions of the first doped polycrystalline silicon layer.

In the description of the embodiments of the present disclosure, the technical terms "first", "second", and the like are merely intended to distinguish different objects, and shall not be understood as an indication or implication of relative importance or implicit indication of the number, specific sequence, or dominant-subordinate relationship of the technical features indicated. In the description of the embodiments of the present disclosure, "a plurality of" means two or more, unless otherwise specifically stated.

The phrase "embodiment" described herein means that specific features, structures, or characteristics described in combination with the embodiments may be incorporated in at least one embodiment of the present disclosure. This phrase appearing at various positions of the specification do not necessarily refer to either the same embodiment or separate or alternative embodiments that are mutually exclusive with other embodiments. It is explicitly and implicitly understood by those skilled in the art that the embodiments described herein may be combined with other embodiments.

In the description of the embodiments of the present disclosure, the term "and/or" herein is merely an association relationship describing associated objects, indicating that three relationships may exist. For example, A and/or B indicates that there are three cases of A alone, A and B together, and B alone. In addition, the character "/" herein generally indicates an "or" relationship between the associated objects.

In the description of the embodiments of the present disclosure, "a plurality of" means two or more (including two). Similarly, "a plurality of groups" means two or more groups (including two groups), and "a plurality of pieces" means two or more pieces (including two pieces).

In the description of the embodiments of the present disclosure, the orientation or position relationships indicated by the technical terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present disclosure and simplify the description only, rather than indicating or implying that the apparatus or element referred to must have a particular orientation or be constructed and operated in a particular orientation, and therefore are not to be interpreted as limiting the embodiments of the present disclosure.

In the illustration of the embodiments of the present disclosure, unless otherwise specified and limited, technical terms such as "installation", "coupling", "connection", or "fixation" should be broadly understood. For example, "connection" may refer to fixed connections, detachable connections, integrated as a whole, mechanical connections or electrical connections, direct connections or indirect connections through an intermediate medium, or internal connections between two components or an interaction relationship between two components. For those skilled in the art, the specific meanings of the above terms in the embodiments of the present disclosure shall be understood according to the specific situations.

In the drawings corresponding to the embodiments of the present disclosure, for better understanding and ease of description, a thickness and an area of a layer are exaggerated. When a component such as a layer, a film, a region, or a substrate is described as being on the other component or on a surface of the other component, the component may be "directly" on the surface of the other component or there may be a third component between the two components. In contrast, when one component is described as being at the surface of the other component or the other component is formed at or provided at a surface of one component, there is no third component between the two components. In addition, when a component is described as being "substantially" formed on the other component, it indicates that the component is neither formed on the entire surface (or a front surface) of the other component, nor formed on part of an edge of the entire surface.

In the description of the embodiments of the present disclosure, when a component "includes" another component, other components are not excluded and may further be included unless otherwise stated. In addition, when components such as layers, films, regions, or plates are referred to as being "on/located on" another component, they may be "directly on" another component (i.e. there is no other components between them) or there may be other components present therebetween. Moreover, when a component such as a layer, a film, a region, or a plate is "directly on" another component, or the component such as a layer, a film, a region, or a plate is at a surface of another component, it indicates that there are no other components between them.

The terms used in the description of the embodiments herein are for describing particular embodiments only and not intended to be limiting. As used in the description of the embodiments described and in the appended claims, "the component" is also intended to include the plural form unless the context clearly indicates otherwise. Herein, a component includes a layer, a film, a region, a plate, or the like.

Various embodiments of the present disclosure will be described in detail below with reference to the accompanying drawings. However, those of ordinary skill in the art shall understand that in the embodiments of the present disclosure, many technical details are provided to enable readers to better understand the embodiments of the present disclosure. However, even without these technical details and various changes and modifications based on the following embodiments, the claimed technical solutions of the present disclosure can still be implemented.

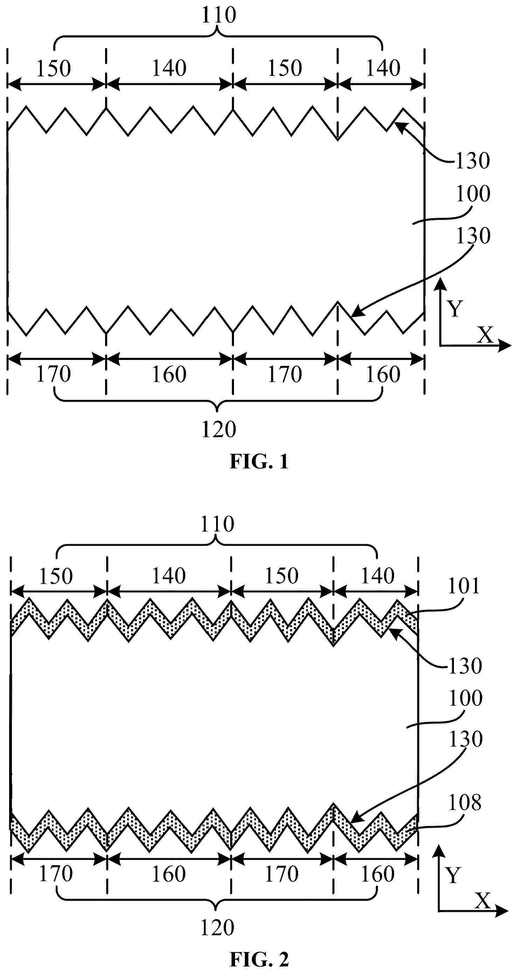

Some embodiments of the present disclosure provide a method for manufacturing a solar cell. In the following, a detailed illustration of the method will be provided in conjunction with the accompanying drawings. FIGS. 1 to 11 are schematic diagrams showing structures of partial cross-sections corresponding to the operations of the method for manufacturing a solar cell according to the embodiments of the present disclosure.

Referring to FIGS. 1 to 11, the method for manufacturing a solar cell includes at least the operations as follows.

At operation S1: referring to FIG. 1, FIG. 1 is a schematic diagram showing a structure of a partial cross-section of a substrate provided in the method for manufacturing a solar cell according to some embodiments of the present disclosure, a substrate 100 including a first surface 110 and an opposing second surface 120 is provided.

In some embodiments, in operation S1, a material of the substrate 100 may be an elemental semiconductor material composed of a single element, such as silicon or germanium. The elemental semiconductor material may be in a single crystalline state, a polycrystalline state, an amorphous state, or a micro crystalline state (referring that the single crystalline state and the amorphous state exist concurrently). For example, silicon may be at least one of monocrystalline silicon, polycrystalline silicon, amorphous silicon, or microcrystalline silicon. In some other embodiments, the material of the substrate 100 may also be a compound semiconductor material. Common compound semiconductor materials include but are not limited to silicon germanium, silicon carbide, gallium arsenide, perovskite, cadmium telluride, copper indium selenide, and the like. Hereinafter, exemplary illustrations in which the material of the substrate 100 is silicon will be provided.

At operation S2: referring to FIG. 2, FIG. 2 is a schematic diagram showing a structure of a partial cross-section of a solar cell with at least the first surface being subjected to doping treatment in the method for manufacturing a solar cell according to some embodiments of the present disclosure, a doped layer 101 is formed by performing doping treatment on at least the first surface 110 using a first doping element.

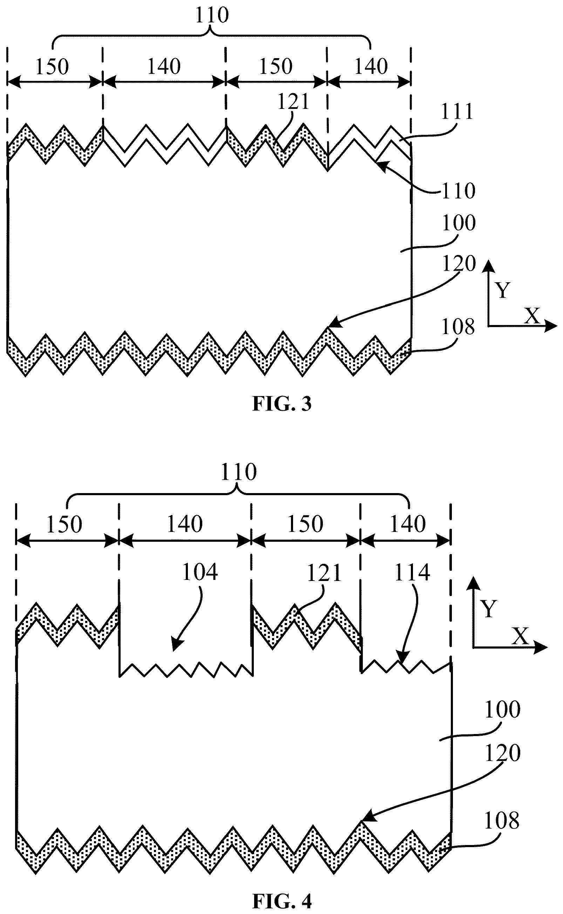

At operation S3: referring to FIGS. 2 and 3, FIG. 3 is a schematic diagram showing a structure of a partial cross-section of a solar cell being subjected to the first laser treatment in the method for manufacturing a solar cell according to some embodiments of the present disclosure, activated portions 111 is formed by performing first laser treatment on portions of the doped layer 101. The doped layer 101 further includes doped portions 121 other than the activated portions 111, and doping concentration of the first doping element in the activated portions 111 is lower than doping concentration in the doped portions 121.

At operation S4: referring to FIGS. 3 and 4, FIG. 4 is a schematic diagram showing a structure of a partial cross-section of a solar cell being subjected to the first etching treatment in the method for manufacturing a solar cell according to some embodiments of the present disclosure, the activated portions 111 is removed and first textured surfaces 114 are formed by performing first etching treatment on the first surface 110. The doped portions 121 function as dead layers.

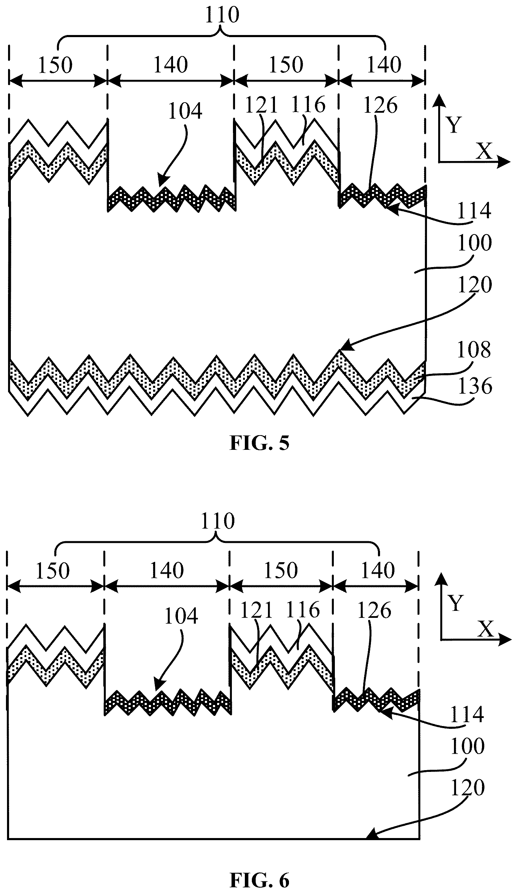

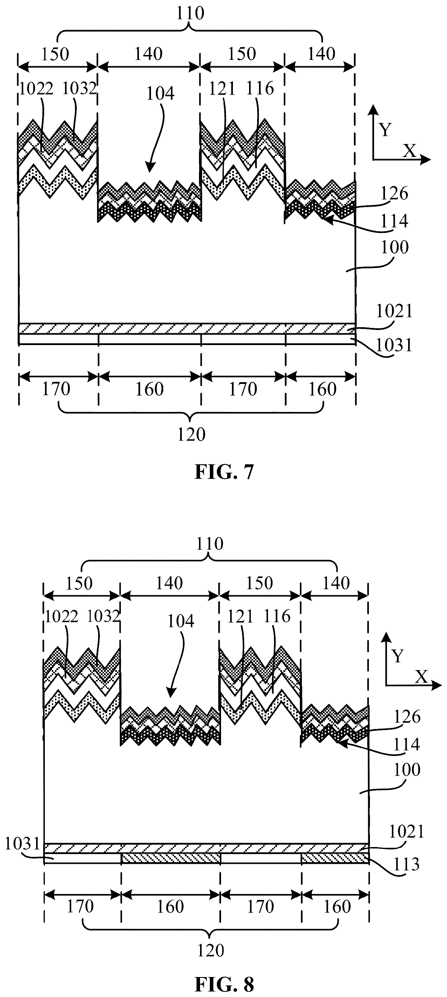

At operation S5: referring to FIGS. 4 to 7, a first doped polycrystalline silicon layer 1021 including a second doping element and a first silicon glass layer 1031 are formed on a side of the substrate 100 away from the doped portions 121. FIG. 5 is a schematic diagram showing a structure of a partial cross-section of a solar cell with at least the first surface being subjected to oxidation treatment in the method for manufacturing a solar cell according to some embodiments of the present disclosure, FIG. 6 is a schematic diagram showing a structure of the partial cross-section of the solar cell in FIG. 5, with the second surface being subjected to polishing treatment, and FIG. 7 is a schematic diagram showing a structure of the partial cross-section of the solar cell in FIG. 6, with the first doped polycrystalline silicon layer, the first silicon glass layer, the second doped polycrystalline silicon layer, and the second silicon glass layer being formed.

At operation S6: referring to FIG. 8, FIG. 8 is a schematic diagram showing a structure of a partial cross-section of a solar cell being subjected to the second laser treatment in the method for manufacturing a solar cell according to some embodiments of the present disclosure, porous portions 113 are formed by performing second laser treatment on at least first portions of the first silicon glass layer 1031.

At operation S7: referring to FIGS. 8 to 11, the porous portions 113 and first portions of the first doped polycrystalline silicon layer 1021 beneath the porous portions 113 are removed and second textured surfaces 115 are formed by performing second etching treatment on at least the side of the substrate away from the doped portions. Remaining second portions of the first silicon glass layer 1031 after removal of the porous portions 113 function as protection layers.

The first doping element has a conductivity type different from that of the second doping element, the first laser treatment uses a laser of a first type, and the second laser treatment uses a laser of a second type different from the first type.

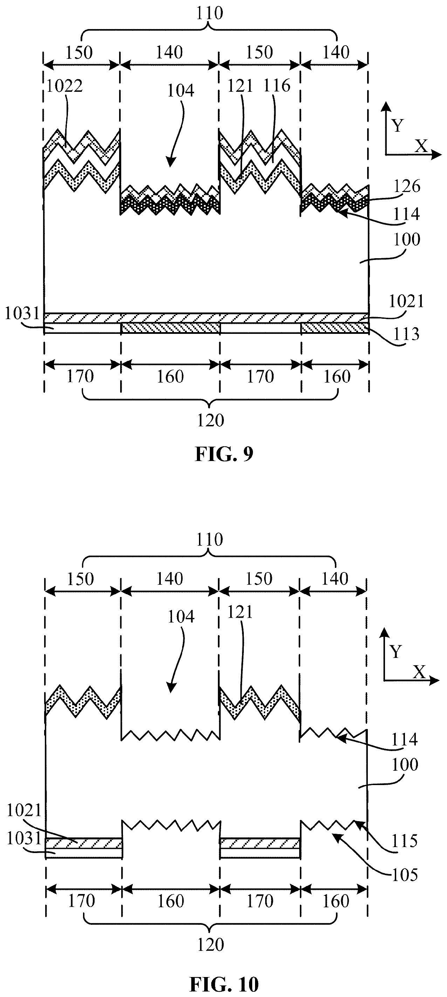

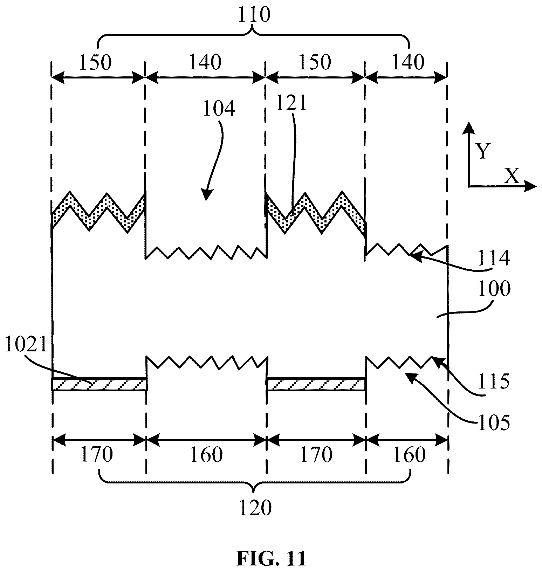

FIG. 9 is a schematic diagram showing a structure of the partial cross-section of the solar cell in FIG. 8, with the first surface being subjected to etching, FIG. 10 is a schematic diagram showing a structure of the partial cross-section of the solar cell in FIG. 9, with the first surface and the second surface being subjected to texturing, and FIG. 11 is a schematic diagram showing a structure of the partial cross-section of the solar cell in FIG. 10, with the second surface being subjected to washing.

It is noted that in addition to the types of lasers used in the first laser treatment and the second laser treatment, the objects that are subjected to the first laser treatment and the second laser treatment are also different.

At operation S3, the first laser treatment is performed on first portions of the doped layer 101 to activate the first portions of the doped layer 101, such that the doping concentration of the first doping element in the first portions of the doped layer 101 is reduced, and the orderliness of the lattice in the first portions of the doped layer 101 is improved, thereby converting the first portions of the doped layer 101 into the activated portions 111, with the remaining second portions of the doped layer 101 that are not subjected to the first laser treatment forming the doped portions 121. In other words, compared to the doped portions 121, the doping concentration of the doping element in the activated portions 111 is lower, which makes the overall orderliness of the lattice in the activated portions 111 stronger. Therefore, under the same etching conditions, it is easier to etch the doped portions 121.

On this basis, at operation S4, when the first surface 110 is subjected to the first etching treatment, the etching rate for the activated portions 111 having lower doping concentration of the first doping element is much higher than that for the doped portions 121. Thus, the activated portions 111 can be removed and the first textured surfaces 114 can be formed with the doped portions 121 functioning as dead layers, without the need of providing additional masks, which is conducive to simplifying the manufacturing process of solar cells. In addition, compared to using laser ablation technology to remove portions of the doped layer 101 (in other words, these portions of the doped layer 101 are directly ablated using laser) and form selective emitter structures with the doped layer 101 is remained in only some regions of the first surface 110, in the method provided in some embodiments of the present disclosure, the combination of the first laser treatment and the first etching treatment is beneficial for reducing the laser damage to the first surface 110. In other words, compared to the laser used in the laser ablation process, the laser used in the first laser treatment brings lower damage to the first surface 110, which is conducive to reducing the surface defect density at the first surface 110 and improving the photoelectric conversion efficiency of the finally formed solar cells.

Moreover, after operation S3, by forming the selective emitter structures with portions of the doped layer 101 (i.e., the doped portions 121) are remained in some regions of the first surface 110, it is beneficial for reducing the contact resistance between the subsequently formed electrodes and the doped portions 121, and reducing the probability of recombination of carriers in other regions of the first surface 110, thereby improving the photoelectric conversion efficiency of the finally formed solar cells.

At operation S6, second laser treatment is performed on at least first portions of the first silicon glass layer 1031 to modify the first portions of the first silicon glass layer 1031 into the porous portions 113, for example resulting in a higher degree of porosity in the porous portions 113 than in the remaining second portions of the first silicon glass layer 1031. On this basis, at operation S7, when performing the second etching treatment on at least the side of the substrate away from the doped portions, the etching rate for the porous portions 113 having higher porosity is much higher than that for the second portions of the first silicon glass layer 1031. Therefore, the porous portions 113 and first portions of the first doped polycrystalline silicon layer 1021 beneath the porous portions 113 can be removed and the second textured surfaces 115 can be formed with the remaining second portions of the first silicon glass layer 1031 functioning as protection layers, without the need of providing additional masks, which is conducive to simplifying the manufacturing process of solar cells.

Moreover, removing the first portions of the first doped polycrystalline silicon layer 1021 beneath the porous portions 113 is conducive to preventing parasitic absorption of light by the removed first portions of the first doped polycrystalline silicon layer 1021. In addition, the exposed second textured surfaces 115 can enhance the absorption and utilization of light, which is conducive to reducing the contact resistance between the subsequently formed electrodes and the second portions of the first doped polycrystalline silicon layer 1021, thereby improving the photoelectric conversion efficiency of the finally formed solar cells.

It is noted that at operation S3, the first laser treatment aims to activate the first portions of the doped layer 101, in order to change the doping concentration of the first doping element in the first portions of the doped layer 101 and the orderliness of the lattice in the first portions of the doped layer 101, thereby forming the activated portions 111 using the first portions of the doped layer 101 having lowered doping concentration of the first doping element. In contrast, at operation S6, the second laser treatment aims to modify at least the first portions of the first silicon glass layer 1031, in order to change porosity in the first portions of the first silicon glass layer 1031, thereby forming the porous portions 113 using the first portions of the first silicon glass layer 1031 having increased porosity.

In some embodiments, doping concentration of the first doping element in the activated portions 111 being lower than doping concentration in the doped portions 121 refers to the situation as follows. Regarding a surface of an individual activated portion 111 away from the substrate 100 as a first reference plane and regarding a surface of an individual doped portion 121 away from the substrate 100 as a second reference plane, the effective doping concentration of the doping element at a depth of 100nm from the first reference plane to the substrate 100 in the activated portion 111 is lower than the effective doping concentration of the doping element at a depth of 100nm from the second reference plane to the substrate 100 in the doped portion 121. In this way, the overall orderliness of the lattice in the activated portions 111 is stronger.

In some embodiments, a ratio of the doping concentration of the doping element in an individual doped portion 121 to the doping concentration of the doping element in an individual activated portion 111 may be in a range from 2 to 100, such as 5, 10, 15, 20, 25, 30, 35, 40, 45, 50, 55, 60, 65, 70, 75, 80, 85, 90, 95, 100, 105, 110, 115, 120, 125, 130, 135, 140, 145, 150, 155, 160, 165, 170, 175, 180, 185, 190, 195, or the like.

In some embodiments, the effective doping concentration in the activated portions 111 and in the doped portions 121 is measured using electrochemical capacitance-voltage profiler (ECV) method. The measured effective doping concentration of the doping element at a depth of 100nm from the first reference plane to the substrate 100 in the activated portion 111 is less than 5×1019 atom/cm3, and the measured effective doping concentration of the doping element at a depth of 100nm from the second reference plane to the substrate 100 in the doped portions 121 is greater than 5×1018 atom/cm3.

It is noted that in the first etching treatment, using the same etching conditions to etch the doped portions 121 and the activated portions 111 refers to using the same etching solution to etch the doped portions 121 and the activated portions 111, and etching the doped portions 121 and the activated portions 111 for the same duration.

In some embodiments, when using the same etching solution, the etching rate of the activated portions 111 is much greater than that of the doped portions 121. Therefore, the etching rate of the first etching treatment on the activated portions 111 having lower doping concentration of the first doping element is much higher than that on the doped portions.

In some embodiments, when using the same etching solution, a ratio of the etching depth on the activated portions 111 per unit time to the etching depth on the doped portions 121 per unit time is greater than or equal to 10. In other words, when using the same etching solution, a ratio of the etching rate of the activated portions 111 to the etching rate of the doped portions 121 is greater than or equal to 10. As an example, the activated portions 111 and the doped portions 121 are concurrently etched, using the same etching solution, for about 600 seconds. The etching depth on an individual activated portion 111 is about 2µm, while the etching depth on an individual doped portion 121 is about 100nm. In other words, compared to the activated portions 111, the doped portions 121 may be considered as almost not etched. During the first etching treatment, when the activated portions 111 are completely removed and the first textured surfaces are formed, at least most of the thicknesses of the doped portions 121 are not etched.

In some embodiments, a higher degree of porosity in the porous portions 113 than in the remaining portions of the first silicon glass layer 1031 refers to that from a microscopic perspective, cracked films can be seen inside the porous portions 113, such as cracks or fragments, and a maximum size of the fragments does not exceed 100µm. Scanning electron microscopy (SEM) may be used to determine the degree of porosity of the porous portions 113 from the microscopic perspective.

In the following, a detailed illustration of the operations of the method for manufacturing a solar cell according to some embodiments of the present disclosure will be provided.

In some embodiments, the substrate 100 may be an N-type semiconductor substrate doped with N-type doping elements, the first doping element is a P-type doping element, and the second doping element is an N-type doping element. In some examples, the N-type doping element may include at least one of the V-group elements such as phosphorus (P), bismuth (Bi), antimony (Sb), or arsenic (As). The P-type semiconductor substrates are doped with P-type elements, which may include at least one of Group-III elements such as boron (B), aluminum (Al), gallium (Ga), or gallium (In).

In some embodiments, at operation S2, the doping treatment performed on at least the first surface 110 may be boron diffusion treatment, so that at least a portion of the substrate 100 doped with boron (B) element forms the doped layer 101, and the doped layer 101 may be regarded as a boron diffused layer. At operation S4, the material of the first doped polycrystalline silicon layer 1021 may be N-type polycrystalline silicon, and the material of the first silicon glass layer 1031 may be phosphorosilicate glass.

In some other embodiments, the substrate may also be a P-type semiconductor substrate doped with P-type doping elements. The first doping element in the doped layer is an N-type doping element, and the second doping element in the first doped polycrystalline silicon layer is a P-type doping element.

In some embodiments, the solar cell is a single-sided solar cell. At operation S1, the first surface 110 may be regarded as the front side of the solar cell, that is, the first surface 110 may function as the light-receiving surface for receiving incident light, and the second surface 120 may function as the back surface. In some other embodiments, the solar cell is a double-sided solar cell, both the first surface 110 and the second surface 120 may function as light-receiving surfaces for receiving incident light. It shall be understood that the back surface described in the embodiments of the present disclosure can also receive incident light, but the degree of reception of incident light is weaker than that of the light-receiving surface, and is therefore defined as a back surface. Hereinafter, exemplary illustrations in which the first surface 110 is a light-receiving surface and the second surface 120 is a back surface will be provided.

In some embodiments, referring to FIG. 3, at operation S3, the first laser treatment may use red nanosecond laser, green nanosecond laser, or purple nanosecond laser; and referring to FIG. 8, at operation S6, the second laser treatment may use green picosecond laser, purple picosecond laser, green femtosecond laser, or purple femtosecond laser. In this way, the doping concentration of the first doping element in the first portions of the doped layer 101 can be reduced using red nanosecond laser, green nanosecond laser, or purple nanosecond laser, thereby converting the first portions of the doped layer 101 having reduced doping concentration of the first doping element into the activated portions 111 to improve the overall orderliness of the lattice in the activated portions 111. The degree of porosity of the first portions of the first silicon glass layer 1031 can be modified using green picosecond laser, purple picosecond laser, green femtosecond laser, or purple femtosecond laser, thereby forming the porous portions 113 from the first portions of the first silicon glass layer 1031 having increased porosity.

It is noted that each of the red nanosecond laser, green nanosecond laser, and purple nanosecond laser is a nanosecond laser, i.e. the first laser treatment uses a short-pulse laser. Each of the green picosecond laser and purple picosecond laser is a picosecond laser, and each of the green femtosecond laser and purple femtosecond laser is a femtosecond laser. Both the picosecond laser and the femtosecond laser belong to ultrashort-pulse laser, i.e. the second laser treatment uses an ultrashort-pulse laser. In other words, the pulse width of the laser used for the first laser treatment is greater than that of the laser used for the second laser treatment.

In some examples, the wavelength of the red nanosecond laser used for the first laser treatment may be in a range from 700nm to 1500nm, such as 730nm, 750nm, 780nm, 800nm, 820nm, 850nm, 880nm, 900nm, 930nm, 950nm, 960nm, 1000nm, 1020nm, 1050nm, 1060nm, 1200nm, 1230nm, 1250nm, 1270nm, 1300nm, 1320nm, 1350nm, 1370nm, 1420nm, 1450nm, 1480nm, or the like.

In some examples, the wavelengths of the green nanosecond laser used for the first laser treatment and the green picosecond laser and green femtosecond laser used for the second laser treatment may each be in a range from 492nm to 577nm, such as 493nm, 495nm, 496nm, 500nm, 502nm, 505nm, 508nm, 510nm, 513nm, 515nm, 516nm, 520nm, 522nm, 525nm, 528nm, 530nm, 532nm, 535nm, 538nm, 540nm, 542nm, 545nm, 548nm, 550nm, 552nm, 555nm, 558nm, 560nm, 562nm, 565nm, 568nm, 570nm, 572nm, 575nm, 578nm, or the like.

In some examples, the wavelengths of the purple nanosecond laser used for the first laser treatment and the purple picosecond laser and purple femtosecond laser used for the second laser treatment may each be in a range from 200nm to 400nm, such as 205nm, 210nm, 215nm, 220nm, 225nm, 230nm, 235nm, 240nm, 245nm, 250nm, 255nm, 260nm, 265nm, 270nm, 275nm, 280nm, 285nm, 290nm, 295nm, 300nm, 305nm, 310nm, 315nm, 320nm, 325nm, 330nm, 335nm, 340nm, 345nm, 350nm, 355nm, 360nm, 365nm, 370nm, 375nm, 380nm, 385nm, 390nm, 395nm, or the like.

In some embodiments, referring to FIGS. 3 and 4, at operation S4, forming the first textured surfaces 114 may include: forming the first textured surfaces 114 and first grooves 104, where each first groove of the first grooves 104 has a respective first textured surface of the first textured surfaces 114 as a bottom surface.

As illustrated above, the etching rate of the first etching treatment for the activated portions 111 is much higher than that for the doped portions 121. On this basis, at operation S4, by using the doped portions 121 as barrier layers, not only will the activated portions 111 be removed, but the portions of the first surface 110 exposed after the removal of the activated portions 111 can also be etched to form first grooves 104. Compared to the portions of the substrate 100 beneath the doped portions 121, the first grooves 104 are recessed into the substrate 100, that is, the first grooves 104 are recessed in the direction directing from the first surface 110 to the second surface 120. In other words, the first surface 110 includes first laser regions 140 and first laser-free regions 150 alternately arranged along a first direction X, the doped portions 121 that are not etched in the first etching treatment are each located at the first laser-free regions 150, and the first grooves 104 are each located at the first laser regions 140. After operation S4, the surfaces of the portions of the substrate 100 at the first laser-free regions 150 are higher than the surfaces of the portions of the substrate 100 at the first laser regions 140, thereby forming the first grooves 104 at the first laser regions 140. Moreover, with the first etching treatment, the portions of the substrate 100 beneath the activated portions 111 can be etched, such that each first groove 104 can have a respective first textured surface 114 as a bottom surface.

In this way, on the one hand, the first textured surfaces 114 can not only reduce the reflectivity of the bottom surface of the first grooves 104, but also can form light traps, thereby enhancing the absorption effect of incident light by the first textured surfaces 114. On the other hand, due to the fact that the first grooves 104 are recessed into the substrate 100, the light incident into the first grooves 104 is less likely to be reflected outside the solar cell, thereby further improving the absorption and utilization efficiency of incident light by the first grooves 104. Therefore, the cooperation of the first grooves 104 and the first textured surfaces 114 can improve the photoelectric conversion efficiency of the solar cell.

It is noted that based on the adjustment of the concentration of the etching solution used in the first etching treatment and/or the treatment duration of the first etching treatment, whether the portions of the first surface 110 exposed after removing the activated portions 111 are etched in the first etching treatment can be controlled, that is, whether the first grooves 104 are formed at the first laser regions 140 on the substrate 100 can be controlled. Furthermore, the degree of etching of the portions of the substrate 100 beneath the activated portions 111 in the first etching treatment can be controlled, that is, the depths of the formed first grooves 104 can be controlled.

In some embodiments, the treatment duration of the first etching treatment may range from 600s to 750s, such as 610s, 620s, 630s, 640s, 650s, 660s, 670s, 680s, 690s, 700s, 710s, 720s, 730s, 740s, or the like.

In some embodiments, a depth of an individual first groove 104 may be in a range from 2.5µm to 4µm, such as 2.6µm, 2.7µm, 2.8µm, 2.9µm, 3µm, 3.1µm, 3.2µm, 3.3µm, 3.4µm, 3.5µm, 3.6µm, 3.7µm, 3.8µm, 3.9µm, or the like.

FIG. 4 shows that the doped portions 121 are left at the first laser-free regions 150 on the substrate 100, and the first grooves 104 are formed at the first laser regions 140 on the substrate 100. In practice, surfaces of the first laser-free regions on the substrate may be substantially flush with surfaces of the first laser regions on the substrate.

In some embodiments, referring to FIGS. 8 to 11, at operation S7, forming the second textured surfaces 115 may include: forming the second textured surfaces 115 and second grooves 105, where each second groove of the second grooves 105 has a respective second textured surface of the second textured surfaces 115 as a bottom surface.

As illustrated above, the etching rate of the second etching treatment for the porous portions 113 is much higher than that for the remaining second portions of the first silicon glass layer 1031. On this basis, at operation S7, by using the second portions of the first silicon glass layer 1031 as protection layers, not only will the porous portions 113 be removed, but the portions of the second surface 120 exposed after the removal of the porous portions 113 can also be etched to form the second grooves 105. Compared to the portions of the substrate 100 beneath the porous portions 113, the second grooves 105 are recessed into the substrate 100, that is, the second grooves 105 are recessed in the direction directing from the second surface 120 to the first surface 110. In other words, the second surface 120 includes second laser regions 160 and second laser-free regions 170 alternately arranged along the first direction X, the second portions of the first silicon glass layer 1031 that are not etched in the second etching treatment are each located at the second laser-free regions 170, and the second grooves 105 are each located at the second laser regions 160. After operation S7, the surfaces of the portions of the substrate 100 at the second laser-free regions 170 are higher than the surfaces of the portions of the substrate 100 at the second laser regions 160, thereby forming the second grooves 105 at the second laser regions 160. Moreover, with the second etching treatment, the portions of the substrate 100 beneath the porous portions 113 can be etched, such that each second groove 105 can have a respective second textured surface 115 as a bottom surface.

In this way, on the one hand, the second textured surfaces 115 can not only reduce the reflectivity of the bottom surface of the second grooves 105, but also can form light traps, thereby enhancing the absorption effect of incident light by the second textured surfaces 115. On the other hand, due to the fact that the second grooves 105 are recessed into the substrate 100, the light incident into the second grooves 105 is less likely to be reflected outside the solar cell, thereby further improving the absorption and utilization efficiency of incident light by the second grooves 105. Therefore, the cooperation of the second grooves 105 and the second textured surfaces 115 can improve the photoelectric conversion efficiency of the solar cell.

It is noted that based on the adjustment of the concentration of the etching solution used in the second etching treatment and/or the treatment duration of the second etching treatment, whether the portions of the second surface 120 exposed after removing the porous portions 113 are etched in the second etching treatment can be controlled, that is, whether the second grooves 105 are formed at the second laser regions 160 on the substrate 100 can be controlled. Furthermore, the degree of etching of the portions of the substrate 100 beneath the porous portions 113 in the second etching treatment can be controlled, that is, the depths of the formed second grooves 105 can be controlled.

In some embodiments, the treatment duration of the second etching treatment may range from 600s to 750s, such as 610s, 620s, 630s, 640s, 650s, 660s, 670s, 680s, 690s, 700s, 710s, 720s, 730s, 740s, or the like.

In some embodiments, a depth of an individual second groove 105 may be in a range from 2µm to 3µm, such as 2.1µm, 2.2µm, 2.3µm, 2.4µm, 2.5µm, 2.6µm, 2.7µm, 2.8µm, 2.9µm, or the like.

FIG. 10 shows that the second portions of the first silicon glass layer 1031 are left at the second laser-free regions 170 on the substrate 100, and the second grooves 105 are formed at the second laser regions 160 on the substrate 100. In practice, surfaces of the second laser-free regions on the substrate may be substantially flush with surfaces of the second laser regions on the substrate.

Moreover, in addition to forming the first grooves 104 each having first textured surfaces 114 as bottom surfaces at operation S4, the second grooves 105 each having second textured surfaces 115 as bottom surfaces may be also formed at operation S7. In other words, the first surface 110 having the first grooves 104 and the second surface 120 having the second grooves 105 may coexist in the finally formed solar cell, which is beneficial for improving the absorption and utilization efficiency of incident light by both the first surface 110 and the second surface 120, thereby improving the double-sided efficiency of the solar cell.

In practice, the first grooves each having first textured surfaces as bottom surfaces may be formed at operation S4, and second textured surfaces substantially flush with the surfaces of the portions of the substrate beneath the second portions of the first silicon glass layer may be formed at operation S7; or the first grooves substantially flush with the surfaces of the portions of the substrate beneath the doped portions may be formed at operation S4, and the second grooves each having second textured surfaces as bottom surfaces may be formed at operation S7; or the first grooves substantially flush with the surfaces of the portions of the substrate beneath the doped portions may be formed at operation S4, and second textured surfaces substantially flush with the surfaces of the portions of the substrate beneath the second portions of the first silicon glass layer may be formed at operation S7. It is noted that the above-mentioned "substantially flush" refers to that the height difference between two surfaces is very small, even is zero.

In some embodiments, referring to FIGS. 2 and 3, at operation S3, an oxide layer is formed on the doped layer 101 during the first laser treatment. Referring to FIGS. 3 and 4, at operation S4, performing the first etching treatment on the first surface 110 may include: removing the oxide layer by etching the first surface 110 using a first chain hydrofluoric acid process. Then, the activated portions 111 are removed and the first textured surfaces 114 are formed by performing the first etching treatment on the first surface 110.

Due to the effect of the laser used in the first laser treatment on the doped layer 101, surfaces of some portions of the doped layer 101 away from the substrate 100 are prone to thermal oxidation, resulting in the oxide layer on the doped layer 101. In some examples, the material of the oxide layer may be silicon oxide.

Thus, the first etching treatment includes two etching processes, i.e. etching the first surface 110 using the first chain hydrofluoric acid process and etching the first surface 110 using the first texturing process, which is beneficial for targeted removal of the oxide layer and the activated portions 111, and for improving the etching accuracy of the first etching treatment. In some examples, at operation S4, in order to finally form the first grooves 104 each having first textured surfaces 114 as bottom surfaces, the first etching treatment is designed to include two etching processes, which is beneficial for forming good step morphologies on the first surface 110, that is, forming controllable surface morphologies of the first grooves 104. For example, it is beneficial for forming first grooves 104 having almost the same depths at various regions.

In some other embodiments, performing first etching treatment on the first surface may include: removing the activated portions and forming the first textured surfaces by etching the first surface using the first texturing process. In other words, the first etching treatment may be the first texturing process, i.e. removal of the oxide layer and of the activated portions and the formation of the first textured surfaces are both achieved using the first texturing process.

In some embodiments, the first surface 110 includes the first laser regions 140 and the first laser-free regions 150 alternately arranged along the first direction X, and the second surface 120 includes the second laser regions 160 and the second laser-free regions 170 alternately arranged along the first direction X. After the first textured surfaces 114 are formed at operation S4, the portions of the first surface 110 at the first laser-free regions 150 are still third textured surfaces 130 (referring to FIG. 1) having third pyramid structures, each of the first textured surfaces 114 has first pyramid structures, and an average dimension of the third pyramid structures is greater than an average dimension of the first pyramid structures.

At operation S1, the first surface 110 of the substrate 100 may be a third textured surface 130. After operations S2 to S4, due to the etching effect of the first etching treatment on the substrate 100, i.e. the further etching on the third textured surfaces 130 at the first laser regions 140, the third textured surfaces 130 at the first laser regions 140 are converted into the first textured surfaces 114. In this way, it is conducive to improving the light-trapping effect of the first textured surfaces 114 by using the first pyramid structures of smaller dimensions.

In some embodiments, referring to FIGS. 1 and 2, the first surface 110 and the second surface 120 provided at operation S1 may be both third textured surfaces 130. Referring to FIGS. 4 to 6, after forming the first textured surfaces 114 at operation S4 and before forming the first doped polycrystalline silicon layer 1021 at operation S5, the method may further include: forming a polished surface by performing polishing treatment on the second surface 120. Referring to FIGS. 6 and 7, forming the first doped polycrystalline silicon layer 1021 and the first silicon glass layer 1031 includes: forming the first doped polycrystalline silicon layer 1021 on the polished surface, and forming the first silicon glass layer 1031 on the surface of the first doped polycrystalline silicon layer 1021 away from the substrate.

It is noted that the flatness of the polished surface is high, and forming the first doped polycrystalline silicon layer 1021 on the polished surface is more conducive to improving the uniformity of the first doped polycrystalline silicon layer 1021, that is, forming a first doped polycrystalline silicon layer 1021 having almost uniform thickness in each region, which is conducive to improving the passivation effect of the first doped polycrystalline silicon layer 1021 on the surface of the substrate 100, thereby improving the photoelectric conversion efficiency of the finally formed solar cell.

In some embodiments, referring to FIG. 2, when performing doping treatment on at least the first surface 110 at operation S2, the doping treatment is also performed on the second surface 120, thereby forming a second doped layer 108 including the first doping element at the second surface 120, with the doped layer 101 formed at the first surface 110 being regarded as a first doped layer. Referring to FIGS. 4 to 6, when polishing the second surface 120, the second doped layer 108 is removed.

In some embodiments, referring to FIG. 5, after forming the first textured surfaces 114 at operation S4 and before forming the polished surface, the method further includes: forming a first diffusion-barrier layer 116 on the doped portions 121 and forming a second diffusion-barrier layer 126 on the first textured surfaces 114 by performing oxidation treatment on at least the first surface 110.

The first diffusion-barrier layer 116 is formed by performing oxidation treatment on partial thicknesses of the doped portions 121. In some examples, the material of the first diffusion-barrier layer 116 may include borosilicate glass. The second diffusion-barrier layer 126 is formed by performing oxidation treatment on partial thicknesses of the substrate 100. In some examples, the material of the second barrier layer 126 may include silicon oxide.

In addition, performing oxidation treatment on at least the first surface 110 will promote the diffusion of the doping element in the doping portions 121 into the substrate 100, thereby deepening the junction depths of the doping portions 121 and improving the junction depths of the PN junctions formed by the doping portions 121 and the substrate 100. Moreover, the doping concentration of the doping element in the doping portions 121 can be slightly reduced to reduce the defect state density at the contacts between the subsequently formed electrodes and the doping portions 121, thereby improving the contact performance between the electrodes and the doping portions 121. On this basis, referring to FIG. 7, at operation S5, the method may further include: forming a second doped polycrystalline silicon layer 1022 on the first diffusion-barrier layer 116 and the second diffusion-barrier layer 126, and forming a second silicon glass layer 1032 on a surface of the second doped polycrystalline silicon layer 1022 away from the substrate. It is noted that during forming the second doped polycrystalline silicon layer 1022 and the second silicon glass layer 1032, the second doping element will gradually diffuse into the second doped polycrystalline silicon layer 1022 due to the effect of high-temperature diffusion. In this way, on the one hand, the first diffusion-barrier layer 116 formed on the doped portions 121 is conducive to blocking the diffusion of the second doping element into the doped portions 121, avoiding the loss of the second doping element, and preventing the modification of the doped portions 121 due to the diffusion of the second doping element, such as modification of the doping portions 121 from P-type to N-type. On the other hand, the second diffusion-barrier layer 126 formed on the first textured surfaces 114 is conducive to blocking the diffusion of the second doping element into the substrate 100, such as the diffusion in the first laser regions 140, in order to avoid the loss of the second doping element.

In some embodiments, after forming the first textured surfaces at operation S4 and before forming the polished surface, the method further includes: forming a first diffusion-barrier layer on the doped portions and forming a second diffusion-barrier layer on the first textured surfaces by performing oxidation treatment on at least the first surface. The first diffusion-barrier layer and the second diffusion-barrier layer together form a surface having a periphery region and a center region surrounded by the periphery region. The method may further include: forming a second doped polycrystalline silicon layer on the periphery region, and forming a second silicon glass layer on a surface of the second doped polycrystalline silicon layer away from the substrate. In other words, at operation S5, when forming the first doped polycrystalline silicon layer and the first silicon glass layer on the second surface, the second doped polycrystalline silicon layer and the second silicon glass layer will be also formed on the periphery region of the surface formed by the first diffusion-barrier layer and the second diffusion-barrier layer due to the wraparound phenomenon. In this way, the first diffusion-barrier layer formed on the doped portions is also conducive to blocking the diffusion of the second doping element into the doped portions, and the second diffusion-barrier layer formed on the first textured surfaces is also conducive to blocking the diffusion of the second doping element into the substrate.

In some embodiments, referring to FIG. 2, at operation S2, the method further includes forming the second doped layer 108 including the first doping element on the second surface 120. Based on this, referring to FIG. 5, when performing oxidation treatment on at least the first surface 110, oxidation treatment is also performed on the second doped layer 108 to form a third diffusion-barrier layer 136 on a side of the second doped layer 108 away from the second surface 120. It is noted that the second diffusion-barrier layer 126 and the third diffusion-barrier layer 136 may be formed in a same oxidation treatment operation. In some examples, the material of the third diffusion-barrier layer 136 and the material of the second diffusion-barrier layer 126 may both be silicon oxide. Furthermore, in the operation of polishing the second surface 120, in addition to the second doped layer 108, the third diffusion-barrier layer 136 is also removed.

In some embodiments, the temperature for the oxidation treatment is in a range from 1000°C to 1100°C, such as 1010°C, 1020°C, 1030°C, 1040°C, 1050°C, 1060°C, 1070°C, 1080°C, 1090°C, or the like.

In some embodiments, referring to FIG. 7, after operation S4, the method may further include: forming a second semiconductor layer (not shown) on the first surface 110 and forming a first semiconductor layer (not shown) on the second surface 120, and forming a second doping source layer (not shown) including the second doping element on a side of the second semiconductor layer away from the substrate 100 and forming a first doping source layer (not shown) including the second doping element on a side of the first semiconductor layer away from the substrate 100. The semiconductor layers and the doping source layers are subjected to high-temperature treatment to promote the diffusion of the second doping element into the semiconductor layers, thereby converting the second semiconductor layer into the second doped polycrystalline silicon layer 1022, converting the first semiconductor layer into the first doped polycrystalline silicon layer 1021, converting the second doping source layer into the second silicon glass layer 1032, and converting the first doping source layer into the first silicon glass layer 1031. In some other embodiments, after operation S4, the method may further include: forming a first semiconductor layer (not shown) on the second surface 120, thereby forming a second semiconductor layer on the periphery region of the surface formed by the first diffusion-barrier layer and the second diffusion-barrier layer together due to the wraparound phenomenon, forming a second doping source layer (not shown) including the second doping element on a side of the second semiconductor layer away from the substrate and forming a first doping source layer (not shown) including the second doping element on a side of the first semiconductor layer away from the substrate, performing high-temperature treatment on the semiconductor layers and the doping source layers to promote the diffusion of the second doping element into the semiconductor layers, thereby converting the second semiconductor layer into the second doped polycrystalline silicon layer, converting the first semiconductor layer into the first doped polycrystalline silicon layer, converting the second doping source layer into the second silicon glass layer, and converting the first doping source layer into the first silicon glass layer.

In some examples, the material of the semiconductor layers may be amorphous silicon, and the high-temperature treatment can promote the crystallization of amorphous silicon to convert into polycrystalline silicon. In some other examples, the material of the semiconductor layers may be polycrystalline silicon.

In some embodiments, referring to FIG. 1, the first surface 110 includes first laser regions 140 and first laser-free regions 150 alternately arranged along the first direction X, and the second surface 120 includes second laser regions 160 and second laser-free regions 170 alternately arranged along the first direction X. Referring to FIG. 3, performing the first laser treatment on the first portions of the doped layer 101 at operation S3 includes: performing the first laser treatment on the first portions that are in the first laser regions 140 to form the activated portions 111 at the first laser regions 140. Referring to FIG. 8, performing the second laser treatment on at least the first portions of the first silicon glass layer 1031, includes: performing the second laser treatment on the first portions of the first silicon glass layer 1031 that are in the second laser regions 160 to form the porous portions 113 at the second laser regions 160.

In this way, in the finally formed solar cell, the doped portions 121 are only at the first laser-free regions 150 and form selective emitters on the first surface 110, which is conducive to ensuring that the subsequent formed electrodes have good current collection efficiency based on the doped portions 121, and preventing the first laser regions 140 from being covered by the doped layer 101, thereby preventing parasitic absorption of light incident on the first laser regions 140 by the doped layer 101, improving the utilization efficiency of incident light by the first surface 110, and improving the photoelectric conversion efficiency of the solar cell.

In some embodiments, referring to FIG. 7, at operation S5, the method further includes: forming a tunneling layer (not shown) between the second surface 120 and the first doped polycrystalline silicon layer 1021. In some examples, the material of the tunneling layer is silicon oxide. On this basis, the second etching treatment in operation S7 is further used to remove portions of the tunneling layer beneath the porous portions 113.

In this way, in the finally formed solar cell, the tunneling layer and the first doped polycrystalline silicon layer are only at the second laser-free regions 170 and form selective passivation contact structures on the second surface 120, which is conducive to ensuring good passivation effect on the second surface 120 by the tunneling layer and the first doped polycrystalline silicon layer 1021, and preventing the second laser regions 160 from being covered by the first doped polycrystalline silicon layer 1021, thereby preventing parasitic absorption of light incident on the second laser regions 160 by the first doped polycrystalline silicon layer 1021, improving the utilization efficiency of incident light by the second surface 120, and improving the photoelectric conversion efficiency of the solar cell.

In some embodiments, referring to FIG. 10 or FIG. 11, each of the first laser-free regions 150 and the second laser-free regions 170 at least includes a respective area where an orthographic projection of a corresponding electrode (not shown) onto the substrate 100 is located. The regions on the first surface 110 except for the first laser-free regions 150 are the first laser regions 140, and the regions on the second surface 120 except for the second laser-free regions 170 is the second laser regions 160. In order to ensure that the layers in contact with the electrodes have relatively high doping concentration or that the regions in contact with the electrodes are high-concentration regions, thereby reducing the contact resistance, an area of one respective first laser-free region 150 or second laser-free region 170 is generally greater than or equal to an area of an orthographic projection of one respective electrode. In other words, the area of the orthographic projection of the respective electrode on the substrate 100 is smaller than the area of the respective first laser-free region or second laser-free region, and the orthographic projection of the respective electrode is must be within the respective first laser-free region or second laser-free region.

There may be a plurality of laser regions and a plurality of laser-free regions, and the laser regions and the laser-free regions are alternately arranged along a specified direction. In other words, one respective laser region may be located between two corresponding adjacent laser-free regions, and one respective laser-free region may be located between two corresponding adjacent laser regions. The plurality of laser regions include the first laser regions 140 and the second laser regions 160, and the plurality of laser-free regions include the first laser-free regions 150 and the second laser-free regions 170.

In some embodiments, referring to FIG. 10 or FIG. 11, a respective orthographic projection of each first laser region of at least some of the first laser regions 140 on the substrate 100 may have an area different from an area of a respective orthographic projection of each second laser region of at least some of the second laser regions 160 on the substrate 100. It is noted that an area of an orthographic projection of one respective first laser region 140 on the first surface 110 may be different from an area of an orthographic projection of one respective second laser region 160 on the first surface 110 (i.e. the respective first laser region 140 may be different from the respective second laser region 160 in dimension) due to differences in types of solar cells, light absorption rates of the first surface 110 and the second surface 120, and dimensions of the subsequently formed doped portions 121 and doped polycrystalline silicon layers 1021 and 1022. Therefore, the method for manufacturing a solar cell provided in the embodiments of the present disclosure is applicable to various solar cells.

In some embodiments, an area of an orthographic projection of one respective first laser region on the first surface may be less than or equal to an area of an orthographic projection of one respective second laser region on the first surface. In some other embodiments, an area of an orthographic projection of one respective first laser region on the first surface may be greater than an area of an orthographic projection of one respective second laser region on the first surface. It is noted that the areas of orthographic projections of the plurality of first laser regions on the first surface may be same as or different from each other, depending on actual needs; and the areas of orthographic projections of the plurality of second laser regions on the first surface may be same as or different from each other, depending on actual needs.

In some embodiments, in a second direction, a respective orthographic projection of each first laser region of at least some of the first laser regions on the substrate misaligns with a respective orthographic projection of each second laser region of at least some of the second laser regions on the substrate. The second direction refers to the thickness direction of the substrate. In other words, one respective first laser region is arranged to not align with one respective second laser region in the thickness direction of the solar cell. In this way, the first laser treatment performed on the first surface at operation S3 and the second laser treatment performed on the second surface at operation S6 can be prevented from being performed on a same portion of the substrate, thereby preventing local repeated overheating and damage to the substrate, which is conducive to improving the electrical performance of the finally formed solar cell.

In an example, one respective first laser region may align with a corresponding second laser-free region in the second direction, that is, the orthographic projection of the respective first laser region on the first surface coincides with the orthographic projection of the corresponding second laser-free region on the first surface. One respective first laser-free region may align with a corresponding second laser region in the second direction, that is, the orthographic projection of the respective first laser-free region on the first surface coincides with the orthographic projection of the corresponding second laser region on the first surface.

In some other embodiments, a respective orthographic projection of each first laser region of at least some of the first laser regions on the first surface may at least partially overlap with a respective orthographic projection of each second laser region of at least some of the second laser regions on the first surface.

It should be noted that in practical applications, a solar cell may have the configuration that an area of an orthographic projection of one respective first laser region on the first surface is different from an area of an orthographic projection of one respective second laser region on the first surface, and the orthographic projection of the respective first laser region on the first surface does not overlap with the orthographic projection of the respective second laser region on the first surface; or a solar cell may have the configuration that an area of an orthographic projection of one respective first laser region on the first surface is different from an area of an orthographic projection of one respective second laser region on the first surface, and the orthographic projection of the respective first laser region on the first surface at least partially overlaps with the orthographic projection of the respective second laser region on the first surface.

In some embodiments, referring to FIGS. 9 and 10, performing the second etching treatment on at least the side of the substrate away from the doped portions may include: removing the second silicon glass layer 1032 over the first surface 110 by etching the first surface 110 using a second chain hydrofluoric acid process, and etching both sides of the substrate corresponding to the first surface 110 and the second surface 120 using a second texturing process to remove the second doped polycrystalline silicon layer 1022, the first diffusion-barrier layer 116, and the second diffusion-barrier layer 126 and expose the first textured surfaces 114 and the doped portions 121, and to remove the porous portions 113 and the first portions of the first doped polycrystalline silicon layer 1021 beneath the porous portions and form the second textured surfaces 115.

It should be noted that at operation S6, only the first portions of the first silicon glass layer 1031 formed over the second surface 120 is subjected to the second laser treatment to form the porous portions 113. The second silicon glass layer 1032 formed over the first surface 110 is not subjected to laser treatment, that is, the remaining second portions of the first silicon glass layer 1031 formed over the second surface 120 and the second silicon glass layer 1032 formed over the first surface 110 are not modified by the second laser treatment in terms of porosity, their porosity is lower than that of the porous portions 113.

On this basis, the second etching treatment includes two etching processes as follows. First, the second silicon glass layer 1032 over the first surface 110 is removed by etching the first surface 110 using the second chain hydrofluoric acid process, which is conducive to prevent unable removal of the second doped polycrystalline silicon layer 1022 on the first surface 110 due to the second texturing process being blocked by the second silicon glass layer 1032 over the first surface 110. Then, the first surface 110 and the second surface 120 are etched, with the second portions of the first silicon glass layer 1031 over the second surface 120 functioning as protection layers, using the second texturing process to remove the second doped polycrystalline silicon layer 1022 over the first surface 110, the first diffusion-barrier layer 116, and the second diffusion-barrier layer 126, and to remove the porous portions 113 and the first portions of the first doped polycrystalline silicon layer 1021 beneath the porous portions, which can ensure that the number of the layers to be removed from the first surface 110 and the second surface 120 using the second texturing process is two, respectively, thereby improving the etching accuracy of the second etching treatment. In some examples, at operation S7, in order to finally form the second grooves 105 each having second textured surfaces 115 as bottom surfaces, the second etching treatment is designed to include two etching processes, which is beneficial for forming good step morphologies on the second surface 120, that is, forming controllable surface morphologies of the second grooves 105. For example, it is beneficial for forming second grooves 105 having almost the same depths at various regions.

In some embodiments, referring to FIGS. 10 and 11, after the second texturing process, the method may further include: removing the second portions of the first silicon glass layer 1031 at the second laser-free regions 170 by washing the second surface 120 using an acid-washing process to expose second portions of the first doped polycrystalline silicon layer 1021 at the second laser-free regions 170.

In summary, the first laser treatment is used to deepen the doping concentration of the first doping element in the first portions of the doped layer 101. On this basis, when the first surface 110 is subsequently subjected to the first etching treatment, the etching rate for the activated portions 111 having lower doping concentration of the first doping element is much higher than that for the doped portions 121. Thus, the activated portions 111 can be removed and the first textured surfaces 114 can be formed with the doped portions 121 functioning as blocking layers, without the need of providing additional masks, which is conducive to simplifying the manufacturing process of solar cells. In addition, compared to using laser ablation technology to remove portions of the doped layer 101, the combination of the first laser treatment and the first etching treatment is beneficial for reducing the laser damage to the first surface 110. Moreover, by forming the selective emitter structures with the doped portions 121 being remained on some regions of the first surface 110, it is beneficial for reducing the contact resistance between the subsequently formed electrodes and the doped portions 121, and reducing the probability of recombination of carriers in other regions of the first surface 110.

The second laser treatment is used to modify first portions of the first silicon glass layer 1031 into porous portions 113. On this basis, when performing the subsequent second etching treatment on at least the side of the substrate away from the doped portions, the etching rate for the porous portions 113 having higher porosity is much higher than that for the remaining portions of the first silicon glass layer 1031. Therefore, the porous portions 113 and first portions of the first doped polycrystalline silicon layer 1021 beneath the porous portions 113 can be removed and the second textured surfaces 115 can be formed with the remaining portions of the first silicon glass layer 1031 functioning as protection layers, without the need of providing additional masks, which is conducive to simplifying the manufacturing process of solar cells. Moreover, removing the first portions of the first doped polycrystalline silicon layer 1021 beneath the porous portions 113 is conducive to preventing parasitic absorption of light by the removed first portions of the first doped polycrystalline silicon layer 1021. The exposed second textured surfaces 115 can enhance the absorption and utilization of light, which is conducive to reducing the contact resistance between the subsequently formed electrodes and the second portions of the first doped polycrystalline silicon layer 1021.

Embodiments of the present disclosure further provide a solar cell manufactured by using the method provided in the above embodiments. In the following, a detailed illustration of the solar cell will be provided in conjunction with the accompanying drawings. It is noted that the content same as or corresponding to that in the above embodiments will not be repeated here.

The solar cell is manufactured by using the method for manufacturing a solar cell provided in the above embodiments.

The solar cell may be cells having passivation structures, such as TOPCON solar cells, PERCs, heterojunction solar cells, or the like, and is manufactured by using the method for manufacturing a solar cell provided in the above embodiments. With the first laser treatment and the second laser treatment using lasers of different types, the doped portions 121 can be formed on only some regions of the first surface 110 and the second portions of the first doped polycrystalline silicon layer 1021 can be formed on only some regions of the second surface 120, and the first textured surfaces 114 at the first surface 110 and the second textured surfaces 115 at the second surface 120 can be exposed, without the need of providing additional masks, thereby improving the utilization efficiency of incident light by the first surface 110 and the second surface 120, and improving the photoelectric conversion efficiency of the formed solar cell.

In some embodiments, referring to FIG. 11, the solar cell includes: the substrate 100 including the first surface 110 and the opposing second surface 120, the first surface 110 includes the first laser regions 140 and the first laser-free regions 150 alternately arranged along the first direction X, and the second surface 120 includes the second laser regions 160 and the second laser-free regions 170 alternately arranged along the first direction X; the doped portions 121 formed at the first laser-free regions 150; the second portions of the first doped polycrystalline silicon layer 1021 at the second laser-free regions 170; the first grooves 104 each formed at the first laser regions 140 and have the first textured surfaces 114 as bottom surfaces; and the second grooves 105 each formed at the second laser regions 160 and have the second textured surfaces 115 as bottom surfaces.

In this way, on the one hand, the first textured surfaces 114 can enhance the absorption effect of incident light, and due to the fact that the first grooves 104 are recessed into the substrate 100, the light incident into the first grooves 104 is less likely to be reflected outside the solar cell, thereby further improving the absorption and utilization efficiency of incident light by the first grooves 104. Therefore, the cooperation of the first grooves 104 and the first textured surfaces 114 can improve the absorption and utilization efficiency of incident light by the first surface 110. On the other hand, the second textured surfaces 115 can enhance the absorption effect of incident light, and due to the fact that the second grooves 105 are recessed into the substrate 100, the light incident into the second grooves 105 is less likely to be reflected outside the solar cell, thereby further improving the absorption and utilization efficiency of incident light by the second grooves 105. Therefore, the cooperation of the second grooves 105 and the second textured surfaces 115 can improve the absorption and utilization efficiency of incident light by the second surface 120. In this way, it is beneficial for improving the photoelectric conversion efficiency of solar cells.

In some embodiments, in the second direction Y, an average depth of the first grooves 104 is greater than an average depth of the second grooves 105. In some examples, the average depth of the first grooves 104 may range from 2.5µm to 4µm, and the average depth of the second grooves 105 may range from 2µm to 3µm.

In some embodiments, the solar cell may further include a tunneling layer formed between the second surface 120 and the first doped polycrystalline silicon layer 1021, and the tunneling layer and the first doped polycrystalline silicon layer 1021 form the selective passivation contact structures on the second surface 120.

Those skilled in the art shall understand that the above-mentioned embodiments are specific examples for implementing the present disclosure. In practice, various changes may be made in form and details without departing from the scope of the present disclosure. Therefore, the patent scope of protection of the present disclosure shall be subject to the scope limited by the appended claims.

## Claims

1. A method for manufacturing a solar cell, comprising:
providing a substrate (100) including a first surface (110) and an opposing second surface (120);
forming a doped layer (101) by performing doping treatment on at least the first surface (110) using a first doping element;
forming activated portions (111) by performing first laser treatment on portions of the doped layer (101), wherein the doped layer (101) further includes doped portions (121) other than the activated portions, and doping concentration of the first doping element in the activated portions (111) is lower than doping concentration in the doped portions (121);
removing the activated portions (111) and forming first textured surfaces (114) by performing first etching treatment on the first surface (110), wherein the doped portions (121) function as dead layers;
forming a first doped polycrystalline silicon layer (1021) including a second doping element and a first silicon glass layer (1031) on a side of the substrate (100) away from the doped portions (121), wherein the first silicon glass layer (1031) is formed on a surface of the first doped polycrystalline silicon layer (1021) away from the substrate (100);
forming porous portions (113) of the first silicon glass layer (1031) by performing second laser treatment on at least first portions of the first silicon glass layer (1031); and
removing the porous portions (113) and first portions of the first doped polycrystalline silicon layer (1021) beneath the porous portions (113) and forming second textured surfaces (115) by performing second etching treatment on at least the side of the substrate (100) away from the doped portions (121), wherein remaining second portions of the first silicon glass layer (1031) after removal of the porous portions (113) function as protection layers;
wherein the first doping element has a conductivity type different from that of the second doping element, the first laser treatment uses a laser of a first type, and the second laser treatment uses a laser of a second type different from the first type.

2. The method according to claim 1, wherein each of the first surface (110) and the second surface (120) is a third textured surface (130), and after forming the first textured surfaces (114) and before forming the first doped polycrystalline silicon layer (1021), the method further includes:
forming a polished surface by performing polishing treatment on the second surface (120); and
wherein forming the first doped polycrystalline silicon layer (1021) and the first silicon glass layer (1031), includes:
forming the first doped polycrystalline silicon layer (1021) on the polished surface, and forming the first silicon glass layer (1031) on the surface of the first doped polycrystalline silicon layer (1021) away from the substrate (100).

3. The method according to claim 2, wherein after forming the first textured surfaces (114) and before forming the polished surface, the method further includes:
forming a first diffusion-barrier layer (116) on the doped portions (121) and forming a second diffusion-barrier layer (126) on the first textured surfaces (114) by performing oxidation treatment on at least the first surface (110); and
wherein the method further includes:
forming a second doped polycrystalline silicon layer (1022) on the first diffusion-barrier layer (116) and the second diffusion-barrier layer (126), and forming a second silicon glass layer (1032) on a surface of the second doped polycrystalline silicon layer (1022) away from the substrate (100).

4. The method according to claim 2, after forming the first textured surfaces (114) and before forming the polished surface, the method further includes:
forming a first diffusion-barrier layer (116) on the doped portions (121) and forming a second diffusion-barrier layer (126) on the first textured surfaces (114) by performing oxidation treatment on at least the first surface (110), wherein the first diffusion-barrier layer (116) and the second diffusion-barrier layer (126) together form a surface having a periphery region and a center region surrounded by the periphery region; and
wherein the method further includes:
forming a second doped polycrystalline silicon layer (1022) on the periphery region, and forming a second silicon glass layer (1032) on a surface of the second doped polycrystalline silicon layer (1022) away from the substrate (100).

5. The method according to claim 3 or claim 4, wherein the first surface (110) includes first laser regions (140) and first laser-free regions (150) alternately arranged along a first direction, and the second surface (120) includes second laser regions (160) and second laser-free regions (170) alternately arranged along the first direction;
wherein performing the first laser treatment on the portions of the doped layer (101), includes: performing the first laser treatment on the portions of the doped layer (101) that are in the first laser regions (140) to form the activated portions (111) at the first laser regions (140); and
wherein performing the second laser treatment on at least the first portions of the first silicon glass layer (1031), includes: performing the second laser treatment on the first portions of the first silicon glass layer (1031) that are in the second laser regions (160) to form the porous portions (113) at the second laser regions (160).

6. The method according to claim 5, wherein a respective orthographic projection of each first laser region of at least some of the first laser regions (140) on the substrate (100) has an area different from an area of a respective orthographic projection of each second laser region of at least some of the second laser regions (160) on the substrate (100); and/or
a respective orthographic projection of each first laser region of at least some of the first laser regions (140) on the substrate (100) at least partially overlaps with a respective orthographic projection of each second laser region of at least some of the second laser regions (160) on the substrate (100).

7. The method according to claim 5, wherein a respective orthographic projection of each first laser region of at least some of the first laser regions (140) on the substrate (100) has an area different from an area of a respective orthographic projection of each second laser region of at least some of the second laser regions (160) on the substrate (100); and/or
in a second direction, a respective orthographic projection of each first laser region of at least some of the first laser regions (140) on the substrate (100) misaligns with a respective orthographic projection of each second laser region of at least some of the second laser regions (160) on the substrate (100), wherein the second direction refers to a thickness direction of the substrate (100).

8. The method according to claim 1, wherein removing the activated portions (111) and forming the first textured surfaces (114) by performing the first etching treatment on the first surface (110), includes:
removing the activated portions (111) and forming the first textured surfaces (114) by etching the first surface (110) using a first texturing process.

9. The method according to claim 8, wherein an oxide layer is formed on the doped layer (101) during the first laser treatment, and
wherein before etching the first surface (110) using the first texturing process, the method further includes: removing the oxide layer by etching the first surface (110) using a first chain hydrofluoric acid process.

10. The method according to claim 5, wherein performing the second etching treatment on at least the side of the substrate (100) away from the doped portions (121), includes:
removing the second silicon glass layer (1032) by etching the first surface (110) using a second chain hydrofluoric acid process; and
etching both sides of the substrate (100) corresponding to the first surface (110) and the second surface (120) using a second texturing process to remove the second doped polycrystalline silicon layer (1022), the first diffusion-barrier layer (116), and the second diffusion-barrier layer (126) and expose the first textured surfaces (114) and the doped portions (121), and to remove the porous portions (113) and the first portions of the first doped polycrystalline silicon layer (1021) beneath the porous portions (113) and form the second textured surfaces (115).

11. The method according to claim 10, wherein after etching the first surface (110) and the second surface (120) using the second texturing process, the method further includes:
removing the second portions of the first silicon glass layer (1031) at the second laser-free regions (170) by washing the second surface (120) using an acid-washing process to expose second portions of the first doped polycrystalline silicon layer (1021) at the second laser-free regions (170).

12. The method according to any one of claims 1 to 11, wherein forming the first textured surfaces (114), includes:
forming the first textured surfaces (114) and first grooves (104);
wherein each first groove of the first grooves (104) has a respective first textured surface of the first textured surfaces (114) as a bottom surface;
wherein forming the second textured surfaces (115), includes:
forming the second textured surfaces (115) and second grooves (105);
wherein each second groove of the second grooves (105) has a respective second textured surface of the second textured surfaces (115) as a bottom surface.

13. The method according to any one of claims 1 to 12, wherein the first laser treatment uses red nanosecond laser, green nanosecond laser, or purple nanosecond laser, and the second laser treatment uses green picosecond laser, purple picosecond laser, green femtosecond laser, or purple femtosecond laser.

14. The method according to any one of claims 1 to 13, wherein for a same etching solution, a ratio of an etching rate of the activated portions (111) to an etching rate of the doped portions (121) is greater than or equal to 10.

15. A solar cell, manufactured by using the method according to any one of claims 1 to 14.
